(19) **Europäisches Patentamt European Patent Office Office européen des brevets**

(11) **EP 4 300 821 B1**

(12) **FASCICULE DE BREVET EUROPEEN**

(45) Date de publication et mention de la délivrance du brevet:
**15.10.2025 Bulletin 2025/42**

(21) Numéro de dépôt: **23182163.8**

(22) Date de dépôt: **28.06.2023**

(51) Classification Internationale des Brevets (IPC):
**H03F 3/24** *(2006.01)*    **H03F 3/195** *(2006.01)*
**H03F 3/213** *(2006.01)*    **H03F 1/02** *(2006.01)*

(52) Classification Coopérative des Brevets (CPC):
**H03F 3/24; H03F 1/0211; H03F 3/195; H03F 3/213;**
H03F 2200/451

(54) **DISPOSITIF DE COMMUNICATION COMPRENANT UN AMPLIFICATEUR DE PUISSANCE ET PROCÉDÉ DE MISE EN OEUVRE**

KOMMUNIKATIONSVORRICHTUNG MIT EINEM LEISTUNGSVERSTÄRKER UND VERFAHREN ZUR IMPLEMENTIERUNG DAVON

COMMUNICATION DEVICE COMPRISING A POWER AMPLIFIER AND METHOD OF OPERATION

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **30.06.2022 FR 2206600**

(43) Date de publication de la demande:
**03.01.2024 Bulletin 2024/01**

(73) Titulaire: **Sagemcom Broadband SAS 92270 Bois-Colombes (FR)**

(72) Inventeur: **CONTAL, Serge 92500 RUEIL-MALMAISON (FR)**

(74) Mandataire: **Novagraaf Technologies Bâtiment O2 2, rue Sarah Bernhardt CS90017 92665 Asnières-sur-Seine Cedex (FR)**

(56) Documents cités:
**EP-A1- 3 089 359    EP-A1- 3 866 336**

## Description

### Domaine technique

Il est décrit un dispositif de communication comprenant un amplificateur de puissance et procédé de mise en oeuvre, pouvant être utilisés notamment dans un réseau sans fil.

### Arrière-plan technique

Un dispositif de communication tel qu'un récepteur/émetteur dans un réseau de communication sans fil peut consommer une énergie non négligeable. Dans un tel dispositif, les circuits liés à l'amplification d'un signal destiné à être émis par une antenne participent grandement à cette consommation. Il est souhaitable d'en réduire la consommation lorsque cela est possible.

Le document EP3089359A1 concerne un dispositif et une méthode pour contrôler un amplificateur de puissance. Le document EP3866336A1 concerne un circuit d'alimentation d'un amplificateur de puissance.

### Résumé

La portée de la protection est déterminée par les revendications. L'invention concerne un dispositif de communication selon la revendication indépendante 1, un procédé mis en œuvre par un dispositif de communication selon la revendication indépendante 5 de type procédé, un produit programme d'ordinateur selon la revendication indépendante 9 et un support d'enregistrement lisible par un dispositif muni d'un processeur selon la revendication 10.

### Brève description des figures

D'autres caractéristiques et avantages apparaitront au cours de la lecture de la description détaillée qui va suivre pour la compréhension de laquelle on se reportera aux dessins annexés parmi lesquels :

Fig.1 - la figure 1 est un algorigramme d'un procédé selon un premier mode de réalisation non limitatif ;
Fig. 2 - la figure 2 est un algorigramme d'un procédé selon un second mode de réalisation non limitatif ;
Fig. 3 - la figure 3 est un diagramme bloc d'un dispositif selon un ou plusieurs modes de réalisation non limitatifs ;
Fig. 4 - la figure 4 est un graphe représentant un module de l'erreur vectorielle en fonction de la puissance à l'émission pour différentes valeurs de tension de polarisation ;
Fig. 5 - la figure 5 est un graphe représentant une densité spectrale de puissance par rapport à un gabarit pour une tension d'alimentation donnée ;
Fig. 6 - la figure 6 est un premier mode de réalisation non limitatif d'une source de tension variable du dispositif selon la figure 1 ;
Fig. 7 - la figure 7 est un second mode de réalisation non limitatif d'une source de tension variable du dispositif selon la figure 1 ;
Fig. 8 - la figure 8 est un troisième mode de réalisation non limitatif d'une source de tension variable du dispositif selon la figure 1.

### Description détaillée

Dans la description qui va suivre, des éléments identiques, similaires ou analogues seront désignés par les mêmes chiffres de référence. Sauf indication contraire, les diagrammes ne sont pas nécessairement à l'échelle.

Les diagrammes blocs, algorigrammes et diagrammes de séquence de messages dans les figures illustrent l'architecture, les fonctionnalités et le fonctionnement de systèmes, dispositifs, procédés et produits programmes d'ordinateur selon un ou plusieurs exemples de réalisation. Chaque bloc d'un diagramme bloc ou chaque phase d'un algorigramme peut représenter un module ou encore une portion de code logiciel comprenant des instructions pour l'implémentation d'une ou plusieurs fonctions. Selon certaines implémentations, l'ordre des blocs ou des phases peut être changé, ou encore les fonctions correspondantes peuvent être mises en oeuvre en parallèle. Les blocs ou phases de procédé peuvent être implémentés à l'aide de circuits, de logiciels ou d'une combinaison de circuits et de logiciels, et ce de façon centralisée, ou de façon distribuée, pour tout ou partie des blocs ou phases. Les systèmes, dispositifs, procédés et méthodes décrits peuvent être modifiés, faire l'objet d'ajouts et/ou de suppressions tout en restant dans le cadre de la présente description. Par exemple, les composants d'un dispositif ou d'un système peuvent être intégrés ou séparés. Également, les fonctions décrites peuvent être mises en oeuvre à l'aide de plus ou de moins de composants ou de phases, ou encore avec d'autres composants ou à travers d'autres phases. Tout système de traitement de données adapté peut être utilisé pour l'implémentation. Un système ou dispositif de traitement de données adapté comprend par exemple une combinaison de code logiciel et de circuits, tels un processeur, contrôleur ou autre circuit adapté pour exécuter le code logiciel. Lorsque le code logiciel est exécuté, le processeur ou contrôleur conduit le système ou dispositif à mettre en oeuvre tout ou partie des fonctionnalités des blocs et/ou des phases des procédés ou méthodes selon les exemples de réalisation. Le code logiciel peut être stocké dans une mémoire ou un support lisible accessible directement ou à travers un autre module par le processeur ou contrôleur.

Dans un réseau de communication, des seuils de puissance maximale en émission par un dispositif émetteur/récepteur peuvent être imposés en fonction d'une bande de fréquence ou sous-bande de fréquence. Par exemple, une règlementation définit pour chaque pays des seuils de puissance maximale par bande ou sous-bande de fréquence dans le cas d'un réseau de communication local sans-fil opérant selon l'un des standards de la famille de standards 802.11 de l'Institut des ingénieurs électriciens et électroniciens (« Institute of Electrical and Electronics Engineers » ou « IEEE » en langue anglaise) ou dit aussi réseau de type 'WiFi'. Dans un autre exemple, certaines dispositions locales reposent sur une coordination des puissances maximales autorisées. L'«AFC » (pour Coordination Automatisée des Fréquences ou « Automated Frequency Coordination » en langue anglaise, régie par le Code des Règlements Fédéraux des Etats-Unis, titre 47, chapitre I, souschapitre A, partie 15, sous-partie E, §15.407(k)) ou « Code of Federal Regulations, Title 47 / Chapter I / Subchapter A / Part 15 / Subpart E / §15.407(k) » en langue anglaise) impose que le dispositif respecte, en fonction de sa localisation, une puissance maximale de transmission.

La puissance qu'un amplificateur de puissance du dispositif devra délivrer peut ainsi être bien inférieure à celle qu'il est effectivement capable de délivrer. Alimenter un amplificateur de puissance en permanence de manière à pouvoir fournir la puissance correspondant au seuil le plus élevé génère donc une surconsommation si seule une puissance moindre sera effectivement utilisée pour la transmission du signal. Dans la présente description, on considérera la valeur efficace de puissance ou encore puissance moyenne quand on parlera de 'puissance'.

Selon un ou plusieurs exemples de réalisation, il est proposé d'adapter dynamiquement la consommation d'un amplificateur de puissance destiné à amplifier un signal à transmettre à la puissance que cet amplificateur doit effectivement délivrer pour ce signal, en d'autres termes la puissance qu'il est nécessaire de transmettre. Cette adaptation est réalisée en ajustant la tension de polarisation de l'amplificateur de puissance en fonction d'un paramètre ou, pour certains modes de réalisation, de plusieurs paramètres, de façon à réduire la réserve de puissance - inutile et inutilisée - de l'amplificateur pour un signal donné.

Selon un ou plusieurs modes de réalisation, le ou les paramètres comprennent le canal de fréquence sur lequel le signal est à transmettre, ainsi qu'optionnellement la modulation du signal. Les paramètres caractérisent le signal ou sa transmission. Le dispositif a accès à des données lui permettant de faire la relation entre le ou les paramètres et la tension à appliquer. On parlera par la suite indistinctement de tension d'alimentation ou de tension de polarisation de l'amplificateur de puissance.

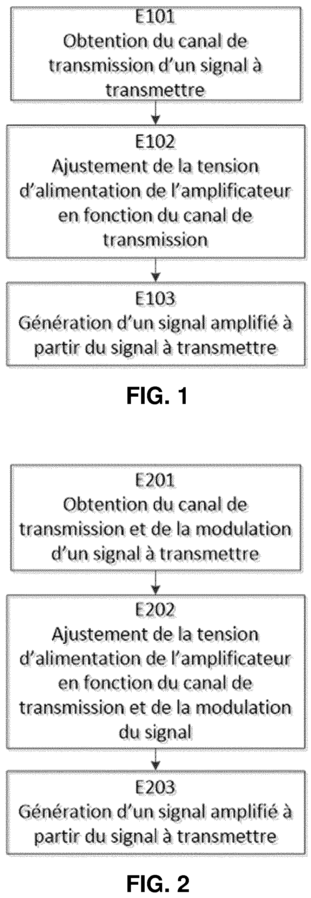

La figure 1 est un algorigramme illustrant un premier procédé selon un ou plusieurs exemples de réalisation. Selon le procédé illustré, un dispositif de communication obtient dans un premier temps (E101) le canal de transmission d'un signal à transmettre. Sur base du canal de transmission, la tension d'alimentation de l'amplificateur est ajustée (E102). Le signal à transmettre est alors amplifié (E103). Une antenne du dispositif ou connectée au dispositif émet le signal amplifié.

La figure 2 est un algorigramme illustrant un second procédé selon un ou plusieurs exemples de réalisation. Selon le procédé illustré, un dispositif de communication obtient dans un premier temps (E201) le canal de transmission d'un signal à transmettre, ainsi que sa modulation. Sur base du canal de transmission et de la modulation, la tension d'alimentation de l'amplificateur est ajustée (E202). Le signal à transmettre est alors amplifié (E203). Une antenne du dispositif ou connectée au dispositif émet le signal amplifié.

Dans ce qui suit, on distinguera la ou les bandes de fréquence dans lesquelles un dispositif peut émettre et/ou recevoir et les canaux fréquentiels compris dans chaque bande de fréquence. A ce titre, les standards 802.11 concernent plusieurs bandes de fréquence : 900 MHz, 2.4 GHz, 3.6 GHz, 4.9 GHz, 5 GHz, 5.9 GHz, 6 GHz et 60 GHz, et chaque bande est divisée en une multitude de canaux fréquentiels. Connaissant un canal, on détermine la bande de fréquence correspondante.

Deux exemples de cas d'usage seront décrits ci-dessous à titre illustratif et non limitatif.

(a) En Europe, une limitation de puissance PIRE (Puissance Isotrope Rayonnée Equivalente) est fixée à 23 dBm pour la bande de fréquence entre 5.15 et 5.35 GHz et 30 dBm pour la bande de fréquence entre 5.5 et 5.72 GHz.

Un dispositif émetteur/récepteur de type 'Wi-Fi' possède par exemple deux alimentations, respectivement à 5V et à 3V, pour le ou les modules frontaux qu'il comporte. Un interrupteur numérique permet d'alimenter un module frontal - et son amplificateur de puissance - avec l'une ou l'autre de ces tensions.

Le dispositif émet sur le canal 100, dont la fréquence centrale est à 5500 MHz et le module frontal est alimenté à 5V. Le dispositif change alors de canal, par exemple suite à la détection d'interférences sur le canal précédemment utilisé. Le canal 36 est choisi. La fréquence centrale de ce canal est à 5180 MHz. La limitation passe donc de 30 dBm PIRE à 23 dBm PIRE.

Si certaines conditions sont remplies, le procédé selon certains modes de réalisation mis en oeuvre par le dispositif peut alors décider de commuter l'alimentation sur 3V.

(b) Aux Etats-Unis d'Amérique, la limitation de puissance maximale autorisée en sortie d'un connecteur antenne est de 30 dBm pour la bande de fréquence entre 5.18 et 5.25 GHz et pour la bande de fréquence entre 5.725 et 5.825 GHz, mais est limitée à 24 dBm pour la bande de fréquence entre 5.25 GHz et 5.35 GHz et pour la bande de fréquence entre 5.47 et 5.725 GHz.

Un dispositif émetteur/récepteur de type 'Wi-Fi' possède une alimentation dont l'asservissement est réglé avec un pont diviseur. Le dispositif émet sur le canal 36 (5180 MHz) une trame avec une modulation BPSK avec une puissance de 1 W (+30 dBm). Pour cette puissance, il a par exemple été déterminé que l'on peut alimenter le module frontal à 4V.

La trame suivante est modulée en 1024QAM, qui est une modulation dite 'forte' par rapport à des modulations QPSK ou 16QAM, dites 'faibles' en référence au nombre de points dans les constellations - plus le nombre de points sera élevé, plus la modulation sera considérée comme 'forte'. Selon un exemple de catégorisation, une modulation QAM sera considérée comme forte à partir du 64QAM inclus. Pour tenir les 1 W à cette modulation sans dégrader le signal, le procédé mis en oeuvre par le dispositif ajuste la valeur de l'alimentation du module frontal à 5 V avant d'envoyer la trame.

Il est ensuite décidé de basculer sur le canal 116 (5580 MHz). La puissance maximale autorisée baisse fortement dans cette plage de fréquence. Le procédé selon certains modes de réalisation mis en oeuvre par le dispositif ajuste la tension d'alimentation à 3 V pour les modulations faibles. Cette tension est augmentée pour les modulations les plus fortes, selon des données mémorisées définies au préalable.

Selon certains modes de réalisation, si un canal fréquentiel chevauche deux bandes imposant des limitations différentes, par exemple en termes de PIRE, la limitation la plus stricte, à savoir le seuil maximal de puissance le plus faible, est retenue. Un tel cas peut se présenter par exemple aux Etats-Unis d'Amérique pour un canal de 160 MHz (80+80 MHz) qui peut se positionner en même temps sur deux bandes de fréquence.

La tension de polarisation appliquée à l'amplificateur de puissance est ajustée pour que l'amplificateur puisse fournir la puissance déterminée pour le signal à transmettre mais que la réserve de puissance au-delà de cette puissance déterminée soit diminuée par rapport à la puissance que l'amplificateur peut fournir à une tension de polarisation nominale. Par tension de polarisation nominale, on entend la tension de polarisation maximale appliquée à l'amplificateur. Cette tension de polarisation nominale peut rester nécessaire pour obtenir la puissance requise pour la transmission de certains signaux, mais pour d'autres signaux, elle peut être abaissée. L'ajustement de la tension de polarisation est donc le cas échéant tel que la puissance pouvant être fournie par l'amplificateur est diminuée par rapport à la puissance nominale, mais toujours supérieure ou égale au seuil de puissance maximale à laquelle le signal est à transmettre. La consommation moyenne de l'amplificateur est réduite par cette adaptation de la tension de polarisation.

Les données permettant de faire la relation entre la ou les caractéristiques du signal et la tension à appliquer peuvent différer selon les modes de réalisation. Selon certains modes de réalisation, elles auront été déterminées préalablement pour respecter les puissances maximales utilisables. Les données prennent en compte les caractéristiques propres à la plateforme matérielle du dispositif. Les puissances maximales utilisables sont par exemple obtenues à partir d'une ou plusieurs contraintes de nature règlementaire et/ou issues d'un ou plusieurs normes ou standards d'industrie ou documents de spécification. Selon certains modes de réalisation, les puissances maximales utilisables varient par zone géographique (par exemple par région, pays, ensemble de pays...).

Selon certains modes de réalisation, ces données permettent de déterminer, en fonction du ou des paramètres mentionnés précédemment, une valeur de la tension à appliquer ou encore ces données identifient un paramètre opératoire d'une source de tension variable qui, quand il est appliqué à la source de tension, a pour effet de générer la tension à la valeur souhaitée.

Selon d'autres modes de réalisation, ces données permettent d'obtenir, en fonction du ou des paramètres, la valeur de puissance maximale utilisable, cette valeur servant d'argument à une fonction caractérisant la plateforme matérielle du dispositif pour l'obtention de la valeur de la tension de polarisation à appliquer à l'amplificateur de puissance.

Selon certains modes de réalisation, le type de modulation du signal est pris en compte pour déterminer la tension à appliquer. Selon d'autres modes de réalisation, la tension à appliquer est la même quelle que soit la modulation et prend en compte le facteur de crête le plus grand parmi les facteurs de crête des modulations utilisables. Selon d'autres modes de réalisation, la modulation du signal n'est pas prise en compte pour déterminer la tension à appliquer.

Un ajustement de la tension d'alimentation de l'amplificateur peut par exemple être réalisé lors d'un changement du canal de communication, lors du démarrage du dispositif ou de son module frontal, et/ou de façon dynamique pour chaque salve. Dans ce dernier cas, une source de tension variable se stabilisant suffisamment rapidement est de préférence utilisé.

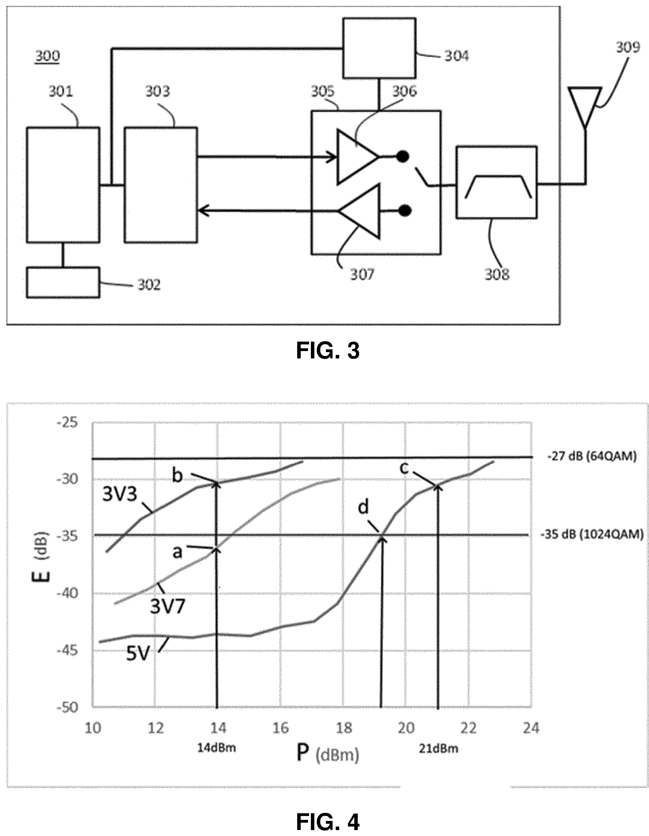

La figure 3 est un diagramme bloc fonctionnel d'un dispositif de communication 300 selon un ou plusieurs modes de réalisation. Le dispositif de la figure 3 comporte un processeur 301 relié à une mémoire 302. La mémoire 302 comporte du code logiciel pouvant être exécuté par le processeur 101 pour conduire le dispositif à mettre en oeuvre les divers procédés décrits. Le dispositif 100 comporte en outre une ou plusieurs chaînes de réception/transmission dont une seule est représentée sur la figure 3. La chaîne de transmission comporte un processeur de signaux numériques et modulateur/démodulateur 303 contrôlé par le processeur 301 ; ainsi qu'un module frontal 305, ce dernier comportant un amplificateur de puissance 306 destiné à amplifier un signal à transmettre reçu du modulateur du bloc 303, ainsi qu'un amplificateur à bas bruit 307 destiné à amplifier un signal reçu et le transmettre au démodulateur du bloc 303. La sortie de l'amplificateur de puissance 306 et l'entrée de l'amplificateur à bas bruit 307 peuvent sélectivement être connectés à une borne d'un filtre passe-bande 308 dont l'autre borne est destinée à être connectée à une antenne 309. Selon l'implémentation, l'antenne 309 peut être externe au dispositif 300 ou être partie intégrante de ce dispositif.

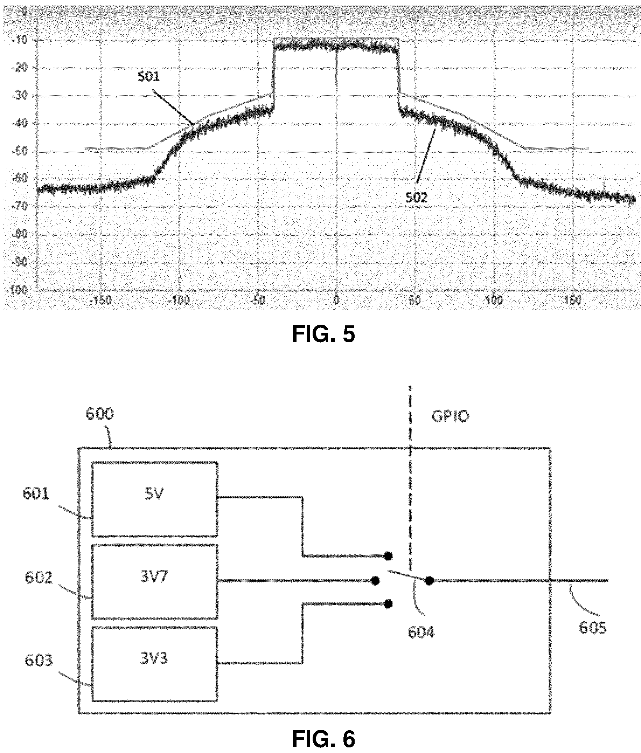

Le dispositif 300 comporte également une source de tension variable 304 dont la sortie alimente l'amplificateur de puissance 306. Selon le présent mode de réalisation, la source de tension est commandée par le processeur 301, qui détermine la tension fournie par la source 304. La mémoire 302 comporte des données utilisées par le processeur 301 pour déterminer la valeur de la tension en fonction d'un ou plusieurs paramètres qui seront décrits plus en détail ci-dessous. La source de tension variable peut être implémentée de diverses manières. Par exemple, une tension peut être sélectionnée par l'intermédiaire d'un commutateur entre plusieurs sources de tension constantes différentes. Il est également possible de prévoir une source de tension pilotée par le processeur, notamment si un ajustement plus fin de la tension d'alimentation est souhaité. Dans le cas d'une source de tension variable proposant des valeurs de tension discrètes, on choisira la valeur discrète de tension égale à la tension à appliquer, ou si cela n'est pas possible, la valeur discrète immédiatement supérieure. Dans le cas d'une implémentation avec des valeurs de tension continues ou très finement ajustables, la tension appliquée sera sensiblement égale ou très légèrement supérieure à la puissance déterminée pour le signal à transmettre. Des exemples d'implémentation de la source de tension variable seront vus plus loin en conjonction avec les figures 6 à 8.

L'amplification d'un signal est préférablement effectuée une fois la tension d'alimentation de l'amplificateur suffisamment stable.

Le dispositif 300 est par exemple un émetteur/récepteur dans un réseau de type 'WiFi'. Dans ce cas, on désignera aussi le signal à transmettre par le terme de 'salve'. Il est entendu par salve l'émission d'une ou plusieurs trames, comprenant par exemple respectivement un préambule et des données utiles, à destination d'un ou plusieurs dispositifs récepteurs.

Un procédé d'obtention des données permettant de déterminer la valeur de la tension à appliquer à l'amplificateur selon un ou plusieurs modes de réalisation sera maintenant décrit. Dans le cadre de cet exemple particulier, les données prendront la forme d'une table de correspondance. Il est à noter que bien qu'il soit ici question de 'table' pour la simplicité de l'explication, il n'est pas nécessaire que les données décrites soient effectivement présentes sous la forme structurelle d'une table - il suffit que les données, quel qu'en soit le format, permettent au dispositif de déterminer une tension à appliquer en fonction du canal et optionnellement en fonction d'un ou plusieurs paramètres supplémentaires. En particulier, les données peuvent être présents sous la forme d'une base de données locale, ou encore distante. Les données de ces bases peuvent également être mises à jour suivant une requête extérieure comme dans le cas d'une requête AFC. Comme indiqué auparavant, les données permettent, en fonction du canal à utiliser pour l'émission d'un signal, d'obtenir la valeur de la tension à appliquer à l'amplificateur. Ou encore, elles permettent de déterminer la puissance maximale utilisable à l'émission et la tension à appliquer à l'amplificateur sera déterminée par une fonction qui donne cette tension en fonction de la puissance. Cette fonction est par exemple une fonction affine ou polynomiale déterminée empiriquement sur base de mesures effectuées sur la plateforme matérielle utilisé, fonction dont les coefficients sont stockés par la passerelle et/ou les radios.

Selon le présent exemple, on détermine dans un premier temps la ou les seuils de puissance maximale autorisée en fonction de la ou des bandes de fréquence de fonctionnement du dispositif.

Selon certains modes de réalisation, on détermine optionnellement si un seuil de puissance maximale fonction d'une bande de fréquence est soumis à une ou plusieurs contraintes supplémentaires pouvant, selon le cas, imposer une baisse supplémentaire du seuil de puissance maximale fonction du canal. Par exemple et de façon non limitative, une contrainte supplémentaire peut être liée au respect d'un critère de qualité. La contrainte supplémentaire peut imposer une limitation supplémentaire du seuil de puissance maximale autorisé, mais ce n'est pas toujours le cas. Dans le cas où une contrainte supplémentaire existe, on choisira comme seuil la plus faible puissance entre la puissance maximale autorisée en fonction de la bande de fréquence et la puissance maximale imposée par la contrainte supplémentaire pour servir de référence pour le choix de la tension à appliquer à l'amplificateur de puissance.

Il est à noter que la mise en oeuvre d'un seuil de puissance maximale fonction du canal et sans tenir compte de contraintes supplémentaires permet déjà d'ajuster la tension d'alimentation de l'amplificateur et ainsi de réduire la consommation. La mise en oeuvre d'une ou plusieurs contraintes supplémentaires permet le cas échéant d'affiner les seuils de puissance maximale fonction du canal et, si cela permet d'utiliser des tensions d'alimentation plus faibles pour un ou plusieurs canaux, de réduire encore plus la consommation.

Une contrainte supplémentaire peut par exemple dépendre du type de modulation appliqué au signal. Sur la base d'une telle contrainte supplémentaire, on peut soit :

1. différencier le seuil de puissance maximale en fonction d'une ou plusieurs modulations particulières et donc disposer potentiellement d'un seuil différent par modulation (ou par groupe de plusieurs modulations), ou encore

2. déterminer un seuil de puissance maximale unique correspondant à une modulation considérée comme imposant le seuil le plus faible.

L'une ou l'autre de ces deux approches peut être utilisée, ou un panachage des deux approches. Par exemple, une approche peut être utilisée pour une première bande de fréquence et l'autre approche peut être utilisée pour une seconde bande de fréquence.

Le comportement de la plateforme matérielle est pris en compte pour déterminer la tension à appliquer pour respecter le seuil de puissance maximale autorisée.

Dans ce qui suit, l'impact de deux contraintes supplémentaires distinctes sur le seuil de puissance maximale déterminé en fonction de la bande de fréquence va être décrit. Dans le cadre du présent exemple, on considère une contrainte portant sur le module de l'erreur vectorielle et une contrainte en fonction d'un masque de puissance en fonction de la fréquence. Pour des raisons de clarté de l'exposé, l'analyse de la première contrainte sera présentée uniquement pour des modulations fortes et l'analyse de la seconde contrainte sera présentée uniquement pour des modulations faibles. Ce choix est dû au fait que pour des modulations fortes, la première contrainte imposera une limitation plus stricte que la seconde contrainte, et pour des modulations faibles, c'est la seconde contrainte qui imposera une limitation plus stricte.

L'impact d'une contrainte relative au module de l'erreur vectorielle va maintenant être décrit. La figure 4 est un graphe représentant une fonction d'erreur E en dB en fonction de la puissance émise en dBm pour différentes tensions discrètes alimentant un amplificateur de puissance d'un module frontal d'un émetteur/récepteur d'un réseau sans fil de type 'WiFi'. La fonction d'erreur est dans le présent cas le module de l'erreur vectorielle ou 'MEV' ('Error Vector Magnitude' ou 'EVM' en langue anglaise), grandeur qui donne une mesure de l'erreur entre les points idéaux d'une constellation de modulation et les points effectivement mesurés. Les courbes pour trois tensions de polarisation sont représentées, respectivement 3.3V, 3.7V et 5V. Dans l'exemple de la figure 4, une trame de type IEEE 802.11ax HE 80MHz MCS11 à une fréquence de 5.5 GHz a été utilisée. Cette trame est choisie car imposant des contraintes plus fortes que d'autres types de trame. Si un seuil MEV est respecté pour une trame de type HE-MCS11, alors ce seuil sera également respecté pour ces autres types de trames. Bien entendu, d'autres trames peuvent être utilisées, selon les besoins des applications envisagées.

Les courbes en fonction des tensions de polarisation de la figure 4 peuvent être obtenues lors de la caractérisation d'un module de transmission avant son industrialisation dans un exemple. Dans un autre exemple, ces mesures de MEV sont réalisées lors d'une phase de test en usine lors de l'assemblage du dispositif de communication comprenant le module de transmission (« Frontend Module » ou 'FEM' en anglais). Encore dans un autre exemple, le dispositif de communication comprenant le module de transmission effectue une phase d'auto-calibration permettant d'effectuer ces mesures de MEV.

A titre d'exemple, pour cette norme, les limites MEV définies par l'IEEE sont respectivement de -35 dB et -27 dB pour respectivement la transmission d'un signal de modulation 1024 QAM et un signal de modulation 64 QAM - ces deux limites sont indiquées schématiquement par deux lignes horizontales dans la figure 4.

(a) La limitation en Europe pour les transmissions sur la bande de fréquence entre 5.15 et 5.35 GHz est de 23 dBm PIRE. A titre d'exemple, avec un gain combiné (ou gain moyen entre les antennes) de 3dBi et pour un système de quatre antennes, la puissance maximale sur chaque antenne sera ainsi de :

[Math. 1]

$$P = PIRE - Gain - 10\log(N_{ant}) \simeq 23 - 3 - 6 \simeq 14\,dBm$$

La valeur de 14 dBm est représentée sur le graphe par une flèche verticale. En dessous de la limite MEV de -35dB, deux courbes de tension présentent une intersection avec la verticale à 14 dBm : la courbe de 3.7V (désignée par 3V7 sur le graphe de la figure 4) et la courbe de 5V. Pour une modulation 1024 QAM, pour émettre à la puissance maximale possible tout en respectant les contraintes imposées, on choisira une tension de 3.7V, dont l'intersection avec la verticale à 14 dBm est située au point 'a', plus proche de la limite du critère d'erreur que par exemple l'intersection de la courbe de la tension à 5V avec la verticale à 14 dBm. Le point 'b' à l'intersection entre la verticale à 14dBm et la courbe 3.3V (désigné par '3V3' sur le graphe de la figure 4) ne respecte pas la contrainte de la limite MEV de -35dB pour une modulation 'forte' 1024QAM. Pour une modulation 64 QAM, on pourra baisser la tension à 3.3V, cette intersection 'b' entre la verticale à 14 dBm et la courbe 3.3V étant l'intersection située en-dessous et la plus proche de la limite MEV de -27db. Selon un mode de réalisation particulier, l'émission est effectuée en-dessous de la puissance maximale par antenne, même s'il est possible d'émettre à cette puissance en respectant les diverses contraintes législatives et/ou techniques imposées.

(b) Pour la bande de fréquences entre 5.5 et 5.72 GHz, une limite de 30 dBm PIRE est autorisée en Europe. Dans le cadre de l'exemple déjà donné ci-dessus (3 dBi de gain combiné et quatre antennes) et en appliquant le même calcul, il en résulte une puissance maximale de 21 dBm par antenne. Cette valeur est également illustrée par une flèche verticale dans le graphe. Une seule courbe présente un point à cette puissance (point 'c'). Cependant, ce point est situé au-dessus de la limite MEV de - 35 dB. On ne pourra donc pas émettre à la puissance maximale autorisée de 21 dBm, du moins avec les valeurs discrètes de tension disponibles dans le présent exemple. On choisira alors la tension de 5V, mais en s'imposant d'émettre à une puissance inférieure ou égale à celle correspondant au point d'intersection 'd', entre la courbe correspondant à la tension de 5V et la limite supérieure MEV de -35 dB, par exemple à une puissance proche de 19 dBm. On respecte ainsi toutes les contraintes imposées. Il est à noter que les tensions de 3.3V et 3.7V ne permettent pas d'émettre à une puissance proche de la puissance maximale imposée. On ne les considère donc pas pour cette bande de fréquence.

L'impact d'une contrainte relative au masque spectral va maintenant être décrit. Selon le présent exemple, pour des modulations dites 'faibles' c'est-à-dire, comme indiqué précédemment, des modulations avec des constellations avec peu de points, ce qui inclut les modulations allant du BPSK au 16 QAM, le masque spectral (ou gabarit) peut imposer une contrainte limitante en termes de puissance. Pour ce faire, on détermine la puissance maximale que l'on peut utiliser tout en restant dans le cadre d'un gabarit imposé. Dans le cadre d'un réseau 'WiFi', ce gabarit est imposé par l'IEEE. La figure 5 est une capture d'écran d'une mesure effectuée pour une trame IEEE 802.11ax telle que mentionnée précédemment, pour une bande de fréquence autour d'une fréquence centrale de 5,53 GHz et une tension de 3.7V. Le gabarit imposé est référencé 501, tandis que le graphe de la puissance en fonction de la fréquence autour de la fréquence centrale est référencé 502. L'axe des abscisses représente la fréquence en MHz autour de la fréquence centrale, tandis que l'axe des ordonnées représente la densité de puissance spectrale en dBm/RBW à 100kHz. Pour ce cas de figure, il a été déterminé que la puissance maximale utilisable permettant de rester dans le gabarit est de 19.35 dBm. Une mesure similaire a été réalisée pour les tensions de 3.3V et 5V respectivement. Le tableau 1 résume les résultats. Il apparaît que même à 3.3V, le spectre sera bien contenu dans le gabarit pour une puissance de 14 dBm. Le gabarit n'impose donc pas de baisser la puissance plus que le seuil maximal imposé mentionné auparavant.

[Tableau 1]

| Tension appliquée | Puissance maximale pour laquelle le spectre est contenu dans le gabarit |
|---|---|
| 5V | 22.16 dBm |
| 3.7V | 19.35 dBm |
| 3.3V | 16.69 dBm |

Le tableau 2 comporte les données qu'un dispositif de communication utilise pour déterminer, à partir du canal à utiliser pour la transmission d'une trame et de la modulation appliquée, la tension de polarisation à appliquer à l'amplificateur de puissance. La première ligne du tableau 2 reprend le point (c) évoqué ci-dessus pour la bande 5.15 à 5.35 GHz. Pour cette même bande, la seconde ligne combine les résultats au point (a) pour les deux modulations 64QAM et 1024QAM en choisissant d'appliquer une même tension de 3.7V - il aurait été possible de distinguer ces deux modulations et d'appliquer une tension de 3.3V pour le 64QAM. On choisit pour des raisons de simplicité d'implémentation de ne disposer que d'une tension. La troisième ligne du tableau prend le cas le plus défavorable tel que discuté en (b) - en effet, la modulation 1024QAM exige une tension de 5V. La personne du métier saura adapter le niveau de détail nécessaire des données.

Il est à noter que le tableau 2 est donné à titre illustratif. Les données stockées dans le dispositif 300 ou telles qu'accessibles par ce dernier à distance peuvent être différentes. Par exemple, la tension appliquée peut simplement être identifiée par un index de source vers laquelle le processeur commutera la sortie de la source de tension variable ('Source 1', 'Source 2', 'Source 3') dans le cas de tensions discrètes, ou encore par référence à une valeur maximale connue, sous la forme d'un ratio (e.g. 50% de la tension maximale), qui servira au processeur pour piloter un générateur de tension variable. Dans un tel cas, inclure une expression explicite de la puissance visée par antenne n'est pas forcément nécessaire car elle ne sera pas utilisée par le dispositif. Comme indiqué précédemment, il est également possible de prévoir d'utiliser une valeur de puissance visée pour en dériver, par exemple grâce à une fonction linéaire ou polynomiale, une valeur de tension à générer, valeur qui servira au processeur pour piloter un générateur de tension variable. La personne du métier saura adapter les données à l'application envisagée et aux spécificités de la plateforme matérielle.

[Tableau 2]

| Bande de fréquence | Modulation | Puissance visée par antenne | Tension appliquée |
|---|---|---|---|
| 5.15 - 5.35 GHz | Faible (BPSK-16QAM) | 14 dBm | 3.3V |
| 5.15 - 5.35 GHz | Forte (64QAM-1024QAM) | 14 dBm | 3.7V |
| 5.5 - 5.72 GHz | Toutes modulations | 19 dBm | 5V |

Le tableau 3 donne un exemple des économies d'énergie pouvant être réalisés selon un exemple spécifique sur un équipement réel fourni à titre illustratif. Le tableau montre que par exemple pour une réduction de la tension d'alimentation du module frontal de 5V à 3.7V, une économie d'environ 1.4W peut être obtenue, soit une baisse de 34%.

[Tableau 3]

| Tension appliquée | Courant | Puissance consommée par 1 FEM émettant 14 dBm | Puissance consommée pour un total de 4 antennes émettant à 14 dBm |
|---|---|---|---|
| 5V | 208 mA | 1.04 W | 4.16 W |
| 3.7V | 190 mA | 0.70 W | 2.73 W |
| 3.3V | 184 mA | 0.61 W | 2.43 W |

Différents modes de réalisation de sources de tension variables vont maintenant être décrits.

La figure 6 est un diagramme bloc d'un premier mode de réalisation d'une source de tension variable. Dans le cas de la figure 6, la source de tension variable 600 comprend autant de sources de tension constante qu'il est nécessaire de disposer de valeurs de tension discrètes, par exemple trois sources 601 à 603. Un commutateur 604 commute l'une des sources de tension constantes vers la sortie 605 de la source de tension variable, sous le contrôle du processeur 301 par l'intermédiaire d'un signal GPIO.

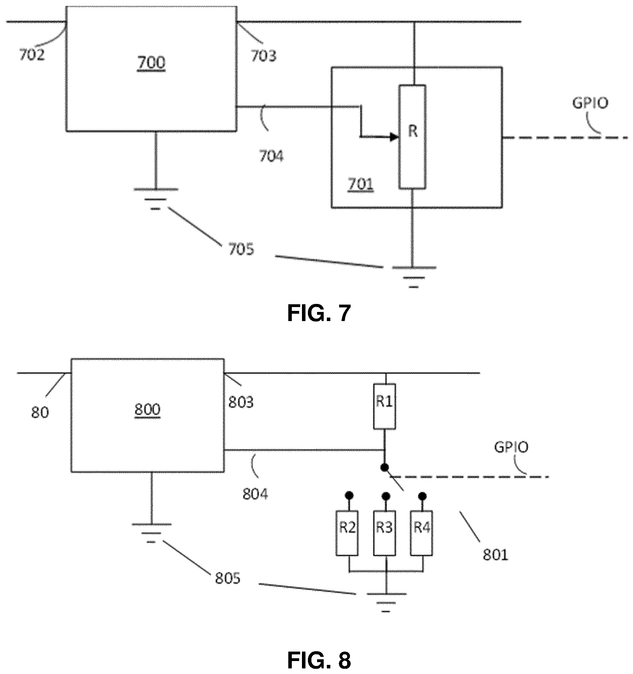

La figure 7 est un diagramme bloc d'un second mode de réalisation d'une source de tension variable. Dans le cas de la figure 7, la source de tension variable comprend une alimentation variable 700 et un potentiomètre 701, dont la sortie est connectée par une ligne 704 à une entrée de boucle de retour de l'alimentation variable 700. L'alimentation variable possède une entrée 702 et une sortie 703, qui fournit la tension d'alimentation désirée. La sortie 703 de l'alimentation 700 est également connectée à une borne du potentiomètre 701, tandis que l'autre borne est connectée à la terre 705. Le potentiomètre 701 est commandé par le processeur 301 par l'intermédiaire d'un signal GPIO - le potentiomètre agit comme un pont diviseur variable et fournit sur la ligne 704 une tension située entre la tension de sortie 703 et la terre et fonction du signal GPIO. La tension en sortie 703 dépend de la tension d'entrée en 702 ainsi que des résistances respectives du pont diviseur. L'asservissement de l'alimentation variable 700 peut donc être réglée en agissant sur le potentiomètre numérique 701.

La figure 8 est un diagramme bloc d'un troisième mode de réalisation d'une source de tension variable. Dans le cas de la figure 8, la source de tension variable comprend une alimentation variable 800 et un pont diviseur 801 dont la sortie est connectée par une ligne 804 à une entrée de boucle de retour de l'alimentation variable 800. L'alimentation variable possède une entrée 802 et une sortie 803, qui fournit la tension d'alimentation désirée. La sortie 803 est également connectée à une borne du pont diviseur 801, tandis que l'autre borne est connectée à la terre 805. Le pont diviseur 801 comprend une résistance R1 reliée à un commutateur qui peut commuter vers trois résistances respectives R2, R3, R4. Le commutateur est commandé par le processeur 301 par l'intermédiaire d'un signal GPIO - le pont diviseur variable ainsi constitué fournit sur la ligne 804 une tension fonction de la tension d'entrée, de la résistance R1 et de l'une des résistances R2 à R4. Les valeurs des résistances sont choisies de façon appropriée pour que la source de tension puisse générer trois valeurs de tension souhaitées. L'asservissement de l'alimentation variable 800 peut être réglée en agissant sur le potentiomètre numérique 801 en commutant vers l'une des résistances R2 à R4.

Dans ce qui précède, divers avantages ont été décrits. Un mode de réalisation spécifique peut présenter un ou plusieurs de ces avantages, mais pas forcément tous les avantages. Certains modes de réalisation peuvent présenter un ou plusieurs avantages non décrits et ne pas présenter d'avantages décrits.

SIGNES DE REFERENCE

300 - Dispositif de communication
301 - Processeur
302 - Mémoire
303 - Processeur de traitement du signal et modulateur RF
304 - Source de tension variable
305 - Module frontal
306 - Amplificateur de puissance
307 - Amplificateur à faible bruit
308 - Filtre passe-bande
309 - Antenne
600 - Source de tension variable
601 - Première source de tension constante
602 - Seconde source de tension constante
603 - Troisième source de tension constante
604 - Commutateur
605 - Sortie de la source de tension variable
700 - Alimentation variable
701 - Potentiomètre numérique
702 - Entrée de l'alimentation variable
703 - Sortie de l'alimentation variable
704 - Ligne de boucle de retour
705 - Terre
800 - Alimentation variable
801 - Potentiomètre numérique
802 - Entrée de l'alimentation variable
803 - Sortie de l'alimentation variable
804 - Ligne de boucle de retour
805 - Terre

**Revendications**

1.  Dispositif de communication (300) comprenant :

    - un amplificateur de puissance (306) configuré pour amplifier un signal destiné à être émis sur un canal fréquentiel;
    - une source de tension variable (304) pour fournir une tension de polarisation de l'amplificateur;
    - une mémoire (302) comportant du code logiciel et un processeur (301) qui, quand il exécute le code logiciel, conduit le dispositif à ajuster la tension de polarisation fournie par la source de tension variable en fonction d'au moins un paramètre comprenant le canal fréquentiel générant ainsi une tension de polarisation ajustée ayant une valeur ajustée;
    - le processeur et le code logiciel étant adaptés pour conduire le dispositif à produire, à partir de données préprogrammées et en fonction de l'au moins un paramètre, un signal de commande de la source de tension variable, ledit signal de commande étant représentatif de la valeur ajustée de la tension de polarisation ;
    **caractérisé en ce que**
    - la tension de polarisation ajustée étant adaptée pour, lorsqu'une puissance que l'amplificateur peut fournir à une tension de polarisation nominale n'est pas nécessaire pour l'émission du signal, diminuer la puissance que l'amplificateur peut fournir suite à l'ajustement, la puissance que l'amplificateur peut fournir suite à l'ajustement étant supérieure ou égale à un seuil de puissance maximale d'émission du signal fonction de l'au moins un paramètre , la diminution visant à réduire une réserve de puissance de l'amplificateur au-delà du seuil ;
    - ledit au moins un paramètre comprenant une modulation du signal, les données préprogrammées étant telles que pour un canal de fréquence donné, une tension de polarisation produite pour une première modulation définie par une constellation comportant un premier nombre de points soit supérieure à une tension de polarisation produite pour une seconde modulation comportant un second nombre de points, le second nombre de points étant supérieur au premier nombre de points.

2. Dispositif selon la revendication 1, les données étant configurées pour permettre au dispositif d'obtenir, en fonction de l'au moins un paramètre, au moins l'un parmi :

- une valeur du signal de commande;
- une valeur de tension de polarisation à utiliser pour le signal ;
- une valeur de puissance d'émission maximale à utiliser pour le signal .

3. Dispositif selon la revendication 2, dans lequel l'au moins une valeur est adaptée à limiter la puissance fournie par l'amplificateur pour respecter au moins l'une parmi :

- une contrainte de puissance maximale fonction d'une bande de fréquence dont le canal fréquentiel fait partie ; ou
- si le canal fréquentiel est en recouvrement avec plusieurs bandes de fréquence, une contrainte la plus stricte parmi des contraintes respectivement fonction de chacune des bandes de fréquence

4. Dispositif selon l'une des revendications 1 à 3, le processeur et le code logiciel étant adaptés pour, dans le cas où la source de tension génère des valeurs discrètes de tension de polarisation, conduire le dispositif à produire une valeur de signal de commande de la source de tension variable correspondant à une valeur discrète de tension égale ou une valeur discrète de tension immédiatement supérieure à une valeur de tension déterminée à partir des données.

5. Procédé mis en œuvre par un dispositif de communication (300) comprenant un amplificateur de puissance (306) configuré pour amplifier un signal destiné à être émis sur un canal fréquentiel; une source de tension variable (304) pour fournir une tension de polarisation de l'amplificateur; une mémoire (302) comportant du code logiciel et un processeur (301) qui, quand il exécute le code logiciel, conduit le dispositif à mettre en œuvre le procédé, le procédé comprenant :

l'ajustement (E102, E202) de la tension de polarisation fournie par la source de tension variable en fonction d'au moins un paramètre comprenant le canal fréquentiel et une modulation du signal générant ainsi une tension de polarisation ajustée ayant une valeur ajustée;
la génération, en fonction de données préprogrammées et de l'au moins un paramètre, d'un signal de commande de la source de tension variable, ledit signal de commande étant représentatif de la valeur ajustée de la tension de polarisation ;
la tension de polarisation ajustée étant adaptée pour, lorsqu'une puissance que l'amplificateur peut fournir à une tension d'alimentation nominale, correspondant à une tension de polarisation maximale, n'est pas nécessaire pour l'émission du signal, diminuer la puissance que l'amplificateur peut fournir suite à l'ajustement, la puissance que l'amplificateur peut fournir suite à l'ajustement étant supérieure ou égale à un seuil de puissance maximale d'émission du signal fonction de l'au moins un paramètre , la diminution visant à réduire une réserve de puissance de l'amplificateur au-delà du seuil ;
ledit au moins un paramètre comprenant une modulation du signal, les données préprogrammées étant telles que pour un canal de fréquence donné, une tension de polarisation produite pour une première modulation définie par une constellation comportant un premier nombre de points soit supérieure à une tension de polarisation produite pour une seconde modulation comportant un second nombre de points, le second nombre de points étant supérieur au premier nombre de points.

6. Procédé selon la revendication 5, les données étant configurées pour permettre au dispositif d'obtenir, en fonction de l'au moins un paramètre, au moins l'un parmi:

une valeur du signal de commande;
une valeur de tension de polarisation à utiliser pour le signal;
une valeur de puissance d'émission maximale à utiliser pour le signal.

7. Procédé selon la revendication 6, selon lequel l'au moins une valeur est adaptée à limiter la puissance fournie par l'amplificateur pour respecter au moins l'une parmi :

- une contrainte de puissance maximale fonction d'une bande de fréquence dont le canal fréquentiel fait partie ; ou
- si le canal fréquentiel est en recouvrement avec plusieurs bandes de fréquence, une contrainte la plus stricte parmi des contraintes respectivement fonction de chacune des bandes de fréquence.

8. Procédé selon l'une des revendications 5 ou 6, comprenant, dans le cas où la source de tension génère des valeurs discrètes de tension de polarisation, la production d'une valeur de signal de commande de la source de tension variable correspondant à une valeur discrète de tension égale ou une valeur discrète de tension immédiatement supérieure à une valeur de tension déterminée à partir des données.

9. Produit programme d'ordinateur comprenant des instructions qui, lorsque le programme est exécuté par un processeur d'un dispositif conduisent l'un des dispositifs ci-dessus à mettre en œuvre le procédé selon l'une des revendications 5 à 8.

10. Support d'enregistrement lisible par un dispositif muni d'un processeur, ledit support comprenant des instructions qui, lorsque le programme est exécuté par un processeur d'un dispositif, conduisent le dispositif à mettre en œuvre le procédé selon l'une des revendications 5 à 8.


**Patentansprüche**

1. Kommunikationsvorrichtung (300), umfassend:

   - einen Leistungsverstärker (306), der zum Verstärken eines Signals konfiguriert ist, das dazu bestimmt ist, auf einem Frequenzkanal gesendet zu werden;
   - eine variable Spannungsquelle (304) zum Bereitstellen einer Vorspannung des Verstärkers;
   - einen Speicher (302), der Softwarecode aufweist, und einen Prozessor (301), der, wenn er den Softwarecode ausführt, die Vorrichtung veranlasst, die Vorspannung, die durch die variable Spannungsquelle bereitgestellt wird, in Abhängigkeit von mindestens einem Parameter anzupassen, umfassend den Frequenzkanal, wobei so eine angepasste Vorspannung erzeugt wird, die einen angepassten Wert besitzt;
   - wobei der Prozessor und der Softwarecode zum Veranlassen der Vorrichtung konfiguriert sind, aus vorprogrammierten Daten und in Abhängigkeit des mindestens einen Parameters ein Signal zum Steuern der variablen Spannungsquelle zu produzieren, wobei das Steuersignal den angepassten Wert der Vorspannung darstellt; **dadurch gekennzeichnet, dass**
   - wenn eine Leistung, die der Verstärker bei einer nominalen Vorspannung bereitstellen kann, für die Sendung des Signals nicht erforderlich ist, die angepasste Vorspannung zum Verringern der Leistung ausgelegt ist, die der Verstärker nach der Anpassung bereitstellen kann, wobei die Leistung, die der Verstärker nach der Anpassung bereitstellen kann, größer als oder gleich einem maximalen Sendeleistungsschwellenwert des Signals in Abhängigkeit von dem mindestens einen Parameter ist, wobei die Verringerung darauf abzielt, eine Leistungsreserve des Verstärkers über den Schwellenwert hinaus zu reduzieren;
   - der mindestens eine Parameter umfassend eine Modulation des Signals, wobei die vorprogrammierten Daten derart sind, dass für einen gegebenen Frequenzkanal eine Vorspannung, die für eine erste Modulation produziert wird, die durch eine Konstellation definiert ist, die eine erste Anzahl von Punkten aufweist, größer als eine Vorspannung ist, die für eine zweite Modulation produziert wird, die eine zweite Anzahl von Punkten aufweist, wobei die zweite Anzahl von Punkten größer als die erste Anzahl von Punkten ist.

2. Vorrichtung nach Anspruch 1, wobei die Daten zum Ermöglichen konfiguriert sind, dass die Vorrichtung in Abhängigkeit von dem mindestens einen Parameter mindestens eines erhält von:

   - einem Wert des Steuersignals;
   - einem Vorspannungswert, der für das Signal verwendet werden soll;
   - einem maximalen Sendeleistungswert, der für das Signal verwendet werden soll.

3. Vorrichtung nach Anspruch 2, wobei der mindestens eine Wert zum Begrenzen der Leistung ausgelegt ist, die durch den Verstärker bereitgestellt wird, zum Einhalten mindestens eines von:

   - einer maximalen Leistungsbeschränkung in Abhängigkeit von dem Frequenzband, zu dem der Frequenzkanal gehört; oder
   - falls sich der Frequenzkanal mit mehreren Frequenzbändern überschneidet, einer strengsten Beschränkung unter den Beschränkungen in Abhängigkeit jeweils von jedem der Frequenzbänder.

4. Vorrichtung nach einem der Ansprüche 1 bis 3, wobei der Prozessor und der Softwarecode in dem Fall, dass die Spannungsquelle diskrete Vorspannungswerte erzeugt, zum Veranlassen der Vorrichtung ausgelegt sind, einen Steuersignalwert der variablen Spannungsquelle zu produzieren, der einem gleichen diskreten Spannungswert oder einem diskreten Spannungswert entspricht, der unmittelbar größer als ein Spannungswert ist, der aus den Daten bestimmt wird.

5. Verfahren, das durch eine Kommunikationsvorrichtung (300) implementiert wird, umfassend einen Leistungsverstärker (306), der zum Verstärken eines Signals konfiguriert ist, das dazu bestimmt ist, auf einem Frequenzkanal gesendet zu werden; eine variable Spannungsquelle (304) zum Bereitstellen einer Vorspannung des Verstärkers; einen Speicher (302), der Softwarecode aufweist, und einen Prozessor (301), der, wenn er den Softwarecode ausführt, die Vorrichtung veranlasst, das Verfahren zu implementieren, das Verfahren umfassend:

Anpassen (E102, E202) der Vorspannung, die durch die variable Spannungsquelle bereitgestellt wird, in Abhängigkeit von mindestens einem Parameter, umfassend den Frequenzkanal und eine Modulation des Signals, wobei so eine angepasste Vorspannung erzeugt wird, die einen angepassten Wert besitzt;
Erzeugen, in Abhängigkeit von vorprogrammierten Daten und dem mindestens einen Parameter, eines Steuersignals der variablen Spannungsquelle, wobei das Steuersignal den angepassten Wert der Vorspannung darstellt;
wobei wenn eine Leistung, die der Verstärker bei einer nominalen Vorspannung bereitstellen kann, die einer maximalen Vorspannung entspricht, für die Sendung des Signals nicht erforderlich ist, die angepasste Vorspannung zum Verringern der Leistung ausgelegt ist, die der Verstärker nach der Anpassung bereitstellen kann, wobei die Leistung, die der Verstärker nach der Anpassung bereitstellen kann, größer als oder gleich einem maximalen Sendeleistungsschwellenwert des Signals in Abhängigkeit von dem mindestens einen Parameter ist, wobei die Verringerung darauf abzielt, eine Leistungsreserve des Verstärkers über den Schwellenwert hinaus zu reduzieren; der mindestens eine Parameter umfassend eine Modulation des Signals, wobei die vorprogrammierten Daten derart sind, dass für einen gegebenen Frequenzkanal eine Vorspannung, die für eine erste Modulation produziert wird, die durch eine Konstellation definiert ist, die eine erste Anzahl von Punkten aufweist, größer als eine Vorspannung ist, die für eine zweite Modulation produziert wird, die eine zweite Anzahl von Punkten aufweist, wobei die zweite Anzahl von Punkten größer als die erste Anzahl von Punkten ist.

6. Verfahren nach Anspruch 5, wobei die Daten zum Ermöglichen konfiguriert sind, dass die Vorrichtung in Abhängigkeit von dem mindestens einen Parameter mindestens eines erhält von:

einem Wert des Steuersignals;
einem Vorspannungswert, der für das Signal verwendet werden soll;
einem maximalen Sendeleistungswert, der für das Signal verwendet werden soll.

7. Verfahren nach Anspruch 6, wobei der mindestens eine Wert zum Begrenzen der Leistung ausgelegt ist, die durch den Verstärker bereitgestellt wird, zum Einhalten mindestens eines von:

- einer maximalen Leistungsbeschränkung in Abhängigkeit von dem Frequenzband, zu dem der Frequenzkanal gehört; oder
- falls sich der Frequenzkanal mit mehreren Frequenzbändern überschneidet, einer strengsten Beschränkung unter den Beschränkungen in Abhängigkeit jeweils von jedem der Frequenzbänder.

8. Verfahren nach einem der Ansprüche 5 oder 6, umfassend in dem Fall, in dem die Spannungsquelle diskrete Vorspannungswerte erzeugt, das Erzeugen eines Steuersignalwerts der variablen Spannungsquelle, der einem gleichen diskreten Spannungswert oder einem diskreten Spannungswert entspricht, der unmittelbar größer als ein Spannungswert ist, der aus den Daten bestimmt wird.

9. Computerprogrammprodukt, umfassend Anweisungen, die, wenn das Programm durch einen Prozessor einer Vorrichtung ausgeführt wird, die eine der obenstehenden Vorrichtungen veranlassen, das Verfahren nach einem der Ansprüche 5 bis 8 zu implementieren.

10. Aufzeichnungsmedium, das durch eine Vorrichtung lesbar ist, die mit einem Prozessor versehen ist, das Medium umfassend Anweisungen, die, wenn das Programm durch einen Prozessor einer Vorrichtung ausgeführt wird, die Vorrichtung veranlassen, das Verfahren nach einem der Ansprüche 5 bis 8 zu implementieren.

# EP 4 300 821 B1

**Claims**

1. Communication device (300) comprising:

   - a power amplifier (306) configured to amplify a signal intended to be emitted on a frequency channel;
   - a variable voltage source (304) for providing a bias voltage of the amplifier;
   - a memory (302) comprising software code and a processor (301) which, when executing the software code, causes the device to adjust the bias voltage supplied by the variable voltage source on the basis of at least one parameter comprising the frequency channel, thereby generating an adjusted bias voltage having an adjusted value;
   - the processor and the software code being adapted to cause the device to produce, from pre-programmed data and on the basis of the at least one parameter, a control signal of the variable voltage source, said control signal being representative of the adjusted value of the bias voltage;
   **characterized in that**
   - the adjusted bias voltage is adapted to, when a power that the amplifier can supply to a nominal bias voltage is not required for signal emission, decrease the power that the amplifier can supply following the adjustment, the power that the amplifier can supply following the adjustment being greater than or equal to a maximum emission power threshold of the signal on the basis of the at least one parameter, the decrease aiming to reduce a power reserve of the amplifier beyond the threshold;
   - said at least one parameter comprising a modulation signal, the pre-programmed data being such that for a given frequency channel, a bias voltage produced for a first modulation defined by a constellation comprising a first number of points is greater than a bias voltage produced for a second modulation comprising a second number of points, the second number of points being greater than the first number of points.

2. Device according to claim 1, the data being configured to allow the device to obtain, on the basis of the at least one parameter, at least one of:

   - a value of the control signal;
   - a bias voltage value to be used for the signal;
   - a maximum emission power value to be used for the signal.

3. Device according to claim 2, wherein the at least one value is adapted to limit the power supplied by the amplifier to respect at least one of:

   - a maximum power constraint on the basis of a frequency band to which frequency channel belongs; or
   - if the frequency channel overlaps with a plurality of frequency bands, the strictest constraint among constraints corresponding to each of the frequency bands.

4. Device according to any of claims 1 to 3, the processor and the software code being adapted to, in the case where the voltage source generates discrete values of bias voltage, cause the device to produce a control signal value of the variable voltage source corresponding to an equal discrete voltage value or a discrete voltage value immediately greater than a voltage value determined from the data.

5. Method implemented by a communication device (300) comprising a power amplifier (306) configured to amplify a signal intended to be emitted on a frequency channel; a variable voltage source (304) for supplying a bias voltage of the amplifier; a memory (302) comprising software code and a processor (301) which, when executing the software code, causes the device to implement the method, the method comprising:

   adjusting (E102, E202) the bias voltage supplied by the variable voltage source on the basis of at least one parameter comprising the frequency channel and a modulation of the signal, thereby generating an adjusted bias voltage having an adjusted value;

   generating, on the basis of pre-programmed data and the at least one parameter, a control signal of the variable voltage source, said control signal being representative of the adjusted value of the bias voltage;

   the adjusted bias voltage being adapted to, when a power that the amplifier can supply at a nominal supply voltage, corresponding to a maximum bias voltage, is not required for signal emission, decrease the power that the amplifier can supply following the adjustment, the power that the amplifier can supply following the adjustment being greater than or equal to a maximum emission power threshold of the signal on the basis of the at least one parameter, the decrease aiming to reduce a power reserve of the amplifier beyond the threshold; said at least one parameter comprising a modulation of the signal, the pre-programmed data being such that for a given frequency channel, a bias voltage produced for a first modulation defined by a constellation comprising a first number of points is greater than a bias voltage produced for a second modulation comprising a second number of points, the second number of points being greater than the first number of points.

6. Method according to claim 5, the data being configured to allow the device to obtain, on the basis of the at least one parameter, at least one of:

   a value of the control signal;
   a bias voltage value to be used for the signal;
   a maximum emission power value to be used for the signal.

7. Method according to claim 6, wherein the at least one value is adapted to limit the power supplied by the amplifier to respect at least one of:

   - a maximum power constraint on the basis of a frequency band to which frequency channel belongs; or
   - if the frequency channel overlaps with a plurality of frequency bands, the strictest constraint among constraints corresponding to each of the frequency bands.

8. Method according to either claim 5 or claim 6, comprising in the case where the voltage source generates discrete values of bias voltage, producing a control signal value of the variable voltage source corresponding to an equal discrete voltage value or a discrete voltage value immediately greater than a voltage value determined from the data.

9. Computer program product comprising instructions which, when the program is executed by a processor of a device, cause one of the aforementioned devices to implement the method according to any of claims 5 to 8.

10. Storage medium readable by a device provided with a processor, said medium comprising instructions which, when the program is executed by a processor of a device, cause the device to implement the method according to any of claims 5 to 8.

**FIG. 1**

**FIG. 2**

**FIG. 3**

**FIG. 4**

**FIG. 5**

**FIG. 6**

**FIG. 7**

**FIG. 8**

**EP 4 300 821 B1**

## RÉFÉRENCES CITÉES DANS LA DESCRIPTION

**Documents brevets cités dans la description**

- EP 3089359 A1

- EP 3866336 A1